# EUROPÄISCHE PATENTSCHRIFT

(11) **EP 3 247 007 B1**
(45) Veröffentlichungstag und Bekanntmachung des Hinweises auf die Patenterteilung: **03.07.2019**
(21) Anmeldenummer: 16170183.4
(22) Anmeldetag: 18.05.2016
(51) Int. Cl.: H01R 43/048, H01R 43/055

(54) **ADAPTERPLATTE-AUSRICHTLEHRE-SYSTEM UND VERFAHREN ZUM AUSRICHTEN EINES CRIMPWERKZEUGES FÜR EINE CRIMPPRESSE**
ADAPTER PLATE ALIGNMENT TEACHING SYSTEM AND METHOD FOR ALIGNING A CRIMPING TOOL FOR A CRIMP PRESS
SYSTEME DE GUIDE D'ALIGNEMENT AVEC PLAQUE D'ADAPTATEUR ET PROCEDE D'ALIGNEMENT D'UN OUTIL DE SERTISSAGE POUR UNE PRESSE DE SERTISSAGE

(43) Veröffentlichungstag der Anmeldung: 22.11.2017
(73) Patentinhaber: Komax Holding AG, 6036 Dierikon (CH)
(72) Erfinder: IMGRÜT, Peter, 6330 Cham (CH); WICKI, Beat, 6043 Adligenswil (CH)
(74) Vertreter: Inventio AG

(56) Entgegenhaltungen:
- DE-U1-202006 020 927

## Beschreibung

Die Erfindung betrifft ein Adapterplatte-Ausrichtlehre-System und ein Verfahren zum Ausrichten eines Crimpwerkzeuges für eine Crimppresse.

Für die Qualität einer Crimpverbindung ist es wichtig, dass die Kabelspitze während des Crimpprozesses bzw. Crimpvorgangs genau zu dem Crimpkontakt ausgerichtet ist. Dabei ist primär die Lage der Kabelspitze in Längsrichtung wichtig, wobei hier eine Toleranz der sog. Einlegetiefe von 0,1 mm oder kleiner gefordert sein kann. Konventionell wird das Crimpwerkzeug von Hand eingesetzt, jedoch ist die Position im Regelfall nicht nach jedem Werkzeugwechsel identisch, da die Werkzeugaufnahme das Crimpwerkzeug nicht wiederholbar an derselben Position festklemmt. Dadurch muss bei Crimpverbindungen mit kleiner Toleranz der Einlegetiefe im Regelfall die Kabelspitze nach jedem Werkzeugwechsel neu ausgerichtet werden.

Nach dem Wechsel eines Crimpwerkzeugs, das in einer Crimppresse installiert ist, gegen ein anderes Crimpwerkzeug muss das Kabel bzw. die Kabelspitze typischerweise relativ zum Crimpwerkzeug wieder neu ausgerichtet werden. Dies führt im Regelfall zu längeren Unterbrechungen des Betriebs der Crimppresse. Dadurch entstehen hohe Kosten. DE 20 2006 020927 U1 beschreibt ein System zum Zentrieren eines Crimpwerkzeugs mit den Merkmalen des Oberbegriffs von Anspruch 1.

Eine der vorliegenden Erfindung zu Grunde liegende Aufgabe ist daher, ein System bzw. Verfahren aufzuzeigen, mittels dem ein Crimpwerkzeug derart angeordnet werden kann, dass nach dem Installieren des Crimpwerkzeugs in der Crimppresse kein Ausrichten des Kabels bzw. der Kabelspitze in Bezug auf das Crimpwerkzeug notwendig ist.

Diese Aufgabe wird durch ein Adapterplatte-Ausrichtlehre-System gemäß Anspruch 1 und ein Verfahren zum Ausrichten eines Crimpwerkzeuges für eine Crimppresse gemäß Anspruch 7 gelöst.

Insbesondere wird die Aufgabe durch ein Adapterplatte-Ausrichtlehre-System umfassend eine Adapterplatte zum Halten eines Crimpwerkzeuges an unterschiedlichen Positionen und eine Ausrichtlehre zum Ausrichten des Crimpwerkzeuges in einer fest vorgegebenen Crimpwerkzeugposition relativ zu der Ausrichtlehre gelöst, wobei die Adapterplatte in einer Crimppresse, die zur Herstellung einer Crimpverbindung mittels des Crimpwerkzeuges, das ein Leiterende eines Kabels mit einem Crimpkontakt verbindet, ausgebildet ist, in einer fest vorgegebenen Adapterplattenposition unbeweglich anordenbar ist, wobei die Ausrichtlehre und die Adapterplatte derart ausgebildet sind, dass die Ausrichtlehre derart an der Adapterplatte befestigbar ist, dass die Ausrichtlehre in einer fest vorgegebenen Ausrichtlehrenposition relativ zu der Adapterplatte angeordnet ist.

Ein Vorteil hiervon ist, dass im Regelfall das Crimpwerkzeug auf der Adapterplatte auch bzw. bereits außerhalb der Crimppresse derart befestigbar ist, dass nach dem Installieren der Adapterplatte mit dem Crimpwerkzeug in der Crimppresse, das Crimpwerkzeug stets an der gleichen Position relativ zur Crimppresse und somit relativ zu dem Kabel angeordnet ist. Hierdurch ist typischerweise ein Neuausrichten bzw. Neupositionieren des Kabels bzw. des Leiterendes des Kabels in Bezug auf das Crimpwerkzeug nach einem Wechsel des Crimpwerkzeugs nicht notwendig. Dies spart Zeit und senkt die Kosten. Zudem können im Regelfall auch Crimpwerkzeuge, die in unterschiedlichen Crimppressen verwendet bzw. installiert werden, stets an der gleichen Position relativ zur Crimppresse bzw. zum Leiterende des Kabels bzw. zum Crimpkontakt unbeweglich angeordnet bzw. fixiert werden. Somit ist ein Neuausrichten bzw. Neupositionieren des Kabels bzw. des Leiterendes des Kabels nach dem Einsetzen des Crimpwerkzeugs in verschiedenen Crimppressen typischerweise nicht notwendig.

In einer Ausführungsform ist zumindest ein Teil der Ausrichtlehre höhenverstellbar ausgebildet und in unterschiedlichen Abständen zu der Adapterplatte arretierbar. Hierdurch kann z.B. ein Finger bzw. Vorsprung der Ausrichtlehre typischerweise zunächst in einer oberen Höhenposition belassen werden, während das Crimpwerkzeug grob in der Crimpwerkzeugposition positioniert wird, und erst dann in eine untere Höhenposition bewegt werden, wenn das Crimpwerkzeug ungefähr richtig positioniert ist. Anschließend kann im Regelfall das Crimpwerkzeug präzise in der Crimpwerkzeugposition positioniert werden. Dies verringert typischerweise die Zeit für das Ausrichten des Crimpwerkzeugs auf der Adapterplatte.

Die Adapterplatte kann zur Aufnahme des Crimpwerkzeuges ausgebildet sein und das Crimpwerkzeug an mehreren unterschiedlichen Positionen, insbesondere kontinuierlich, an der Adapterplatte lösbar unbeweglich befestigbar sein. Hierdurch wird sichergestellt, dass typischerweise das Crimpwerkzeug technisch einfach präzise in der Crimpwerkzeugposition angeordnet und befestigt werden kann. Kontinuierlich bedeutet, dass die verschiedenen Positionen des Crimpwerkzeugs kontinuierlich über die Adapterplatte verteilt sind, d.h. das Crimpwerkzeug nicht in festen Schritten verschiebbar und nur in bestimmten Positionen an der Adapterplatte befestigbar ist, sondern das Crimpwerkzeug in beliebig kleinen Schritten verschiebbar ist und in jeder Position nach dem Verschieben des Crimpwerkzeugs relativ zur Adapterplatte an der Adapterplatte befestigbar ist.

In einer weiteren Ausführungsform weist die Adapterplatte einen Adapterplattenrahmen und eine Aufnahmeplatte auf, wobei die Aufnahmeplatte relativ zu dem Adapterplattenrahmen verschiebbar ausgebildet ist und die Aufnahmeplatte an dem Adapterplattenrahmen in unterschiedlichen Positionen unbeweglich befestigbar ist, und wobei die Aufnahmeplatte derart ausgebildet ist, dass das Crimpwerkzeug an der Aufnahmeplatte lösbar unbeweglich befestigbar ist. Hierdurch lässt sich das Crimpwerkzeug technisch einfach an der Adapterplatte befestigen.

In einer weiteren Ausführungsform umfasst das Adapterplatte-Ausrichtlehre-System ferner eine Grundplatte, wobei die Ausrichtlehre und die Grundplatte derart ausgebildet sind, dass die Ausrichtlehre in der Ausrichtlehrenposition an der Grundplatte befestigbar ist, wobei die Grundplatte an der vorgegebenen Adapterplattenposition an der Crimppresse derart unbeweglich lösbar befestigbar ist, dass sich die Ausrichtlehre in einer Position relativ zu der Crimppresse befindet, die der Position der Ausrichtlehre entspricht, wenn die Ausrichtlehre in der Ausrichtlehrenposition an der Adapterplatte befestigt ist und die Adapterplatte an der Adapterplattenposition in der Crimppresse unbeweglich angeordnet ist. Hierdurch ist es möglich, eine Grundplatte, die technisch einfacher und kostengünstiger ausgebildet ist als die Adapterplatte, zu verwenden, um das Kabel relativ zu der Crimppresse bzw. den Crimpkontakten derart zu positionieren, dass das Leiterende des Kabels in Bezug auf das Crimpwerkzeug, das wiederum relativ zur Ausrichtlehre ausgerichtet ist, ausgerichtet ist. Wenn das Kabel, an dessen Leiterende der Crimpkontakt angebracht werden soll, zu der an der Grundplatte befestigten Ausrichtlehre ausgerichtet ist und das Crimpwerkzeug zu der an der Adapterplatte befestigten Ausrichtlehre ausgerichtet ist, ist typischerweise das Crimpwerkzeug nach dem Installieren der Adapterplatte mit dem Crimpwerkzeug in der Crimppresse mit dem Leiterende des Kabels ausgerichtet, so dass ohne weiteres Ausrichten nach dem Installieren der Adapterplatte mit dem Crimpwerkzeug in der Crimppresse der Crimpvorgang durchgeführt bzw. die Crimppresse betrieben werden kann.

Die Ausrichtlehre kann einen sich verjüngenden Vorsprung aufweisen. Ein Vorteil hiervon ist, dass das Crimpwerkzeug im Regelfall noch präziser in der Crimpwerkzeugposition ausgerichtet werden kann.

Insbesondere wird die Aufgabe auch durch ein Verfahren zum Ausrichten eines Crimpwerkzeuges für eine Crimppresse, die zur Herstellung einer Crimpverbindung mittels des Crimpwerkzeuges, das ein Leiterende eines Kabels mit einem Crimpkontakt verbindet, ausgebildet ist, relativ zu einer Adapterplatte, wobei das Crimpwerkzeug an unterschiedlichen Positionen an der Adapterplatte lösbar unbeweglich befestigbar ist, gelöst, wobei das Verfahren folgende Schritte umfasst: Befestigen der Ausrichtlehre an der Adapterplatte derart, dass die Ausrichtlehre in einer fest vorgegebenen Ausrichtlehrenposition relativ zu der Adapterplatte angeordnet ist, Verschieben des Crimpwerkzeuges relativ zur Adapterplatte, bis sich das Crimpwerkzeug in einer fest vorgegebenen Crimpwerkzeugposition relativ zu der Ausrichtlehre befindet, und Befestigen des Crimpwerkzeuges an der Adapterplatte, so dass das Crimpwerkzeug relativ zur Adapterplatte lösbar unbeweglich befestigt ist.

Ein Vorteil hiervon ist, dass das Crimpwerkzeug typischerweise auf der Adapterplatte auch außerhalb der Crimppresse derart befestigt wird, dass nach dem Installieren der Adapterplatte mit dem Crimpwerkzeug in der Crimppresse, das Crimpwerkzeug stets an der gleichen Position relativ zur Crimppresse bzw. zu dem Leiterende des Kabels bzw. dem Crimpkontakten angeordnet ist. Hierdurch ist ein Neuausrichten bzw. Neupositionieren des Crimpwerkzeugs in Bezug auf die Crimppresse bzw. das Kabel bzw. den Crimpkontakt nach einem Wechsel des Crimpwerkzeugs typischerweise nicht notwendig. Dies spart Zeit und senkt die Kosten. Zudem werden im Regelfall auch Crimpwerkzeuge, die in unterschiedlichen Crimppressen verwendet werden, stets an der gleichen Position relativ zur Crimppresse bzw. zum Crimpkontakt angeordnet bzw. fixiert. Somit ist ein Neuausrichten bzw. Neupositionieren des Crimpwerkzeugs nach dem Installieren des Crimpwerkzeugs in verschiedenen Crimppressen typischerweise nicht notwendig.

Das Verfahren kann ferner den Schritt des Ausrichtens des Leiterendes des Kabels relativ zur Ausrichtlehre, während die Adapterplatte mit der Ausrichtlehre in der Crimppresse unbeweglich lösbar angeordnet ist, umfassen. Ein Vorteil hiervon ist, dass typischerweise sichergestellt wird, dass das Crimpwerkzeug beim Anordnen in der Crimpwerkzeugposition in Bezug auf das Leiterende des Kabels in der Prozessposition angeordnet wird.

Der Schritt des Ausrichtens des Leiterendes des Kabels relativ zur Ausrichtlehre kann ausgeführt werden, während die Ausrichtlehre an der Adapterplatte ohne ein Crimpwerkzeug oder an einer Grundplatte befestigt ist, die in der Crimppresse derart unbeweglich angeordnet ist, dass sich die Ausrichtlehre in einer Position relativ zu der Crimppresse befindet, die der Position der Ausrichtlehre entspricht, wenn die Ausrichtlehre in der Ausrichtlehrenposition an der Adapterplatte befestigt ist und die Adapterplatte an der Adapterplattenposition in der Crimppresse unbeweglich angeordnet ist. Hierbei kann eine Grundplatte, die technisch einfacher und kostengünstiger ausgebildet ist als die Adapterplatte, verwendet werden, um das Kabel relativ zu der Crimppresse bzw. den Crimpkontakten derart zu positionieren, dass das Leiterende des Kabels in Bezug auf das Crimpwerkzeug, das wiederum relativ zur Ausrichtlehre ausgerichtet ist, ausgerichtet ist. Dies senkt typischerweise die Kosten und vereinfacht das Handling.

Das Verschieben des Crimpwerkzeuges relativ zur Adapterplatte, bis sich das Crimpwerkzeug an der bestimmten Crimpwerkzeugposition relativ zu der Ausrichtlehre befindet, kann durchgeführt werden, indem das Crimpwerkzeug grob in der Crimpwerkzeugposition ausgerichtet wird, während sich ein höhenverstellbarer Teil der Ausrichtlehre in einem ersten Abstand zu der Adapterplatte befindet, und das Crimpwerkzeug präzise in der Crimpwerkzeugposition ausgerichtet wird, während sich der höhenverstellbare Teil in einem zweiten Abstand zu der Adapterplatte befindet, wobei der zweite Abstand kleiner als der erste Abstand ist. Dies verringert im Regelfall die Zeit für das Ausrichten des Crimpwerkzeugs auf der Adapterplatte, da während des Ausrichtens die Position des Crimpwerkzeugs besser sichtbar ist.

Das Verfahren kann ferner zusätzlich einen Schritt des unbeweglichen Befestigens des Crimpwerkzeugs auf einer Aufnahmeplatte umfassen, wobei die Adapterplatte einen Adapterplattenrahmen und die Aufnahmeplatte aufweist. Bei diesem Schritt des Verschiebens des Crimpwerkzeuges relativ zum Adapterplattenrahmen, bis sich das Crimpwerkzeug in der fest vorgegebenen Crimpwerkzeugposition relativ zu der Ausrichtlehre befindet, wird das Crimpwerkzeug zusammen mit der Aufnahmeplatte relativ zum Adapterplattenrahmen verschoben, und bei dem Schritt des Befestigens des Crimpwerkzeuges an der Aufnahmeplatte, so dass das Crimpwerkzeug relativ zur Aufnahmeplatte lösbar unbeweglich befestigt ist, die Aufnahmeplatte am Adapterplattenrahmen lösbar unbeweglich befestigt wird. Hierdurch wird das Crimpwerkzeug technisch einfach ausgerichtet.

Es wird darauf hingewiesen, dass einige der möglichen Merkmale und Vorteile der Erfindung hierin mit Bezug auf unterschiedliche Ausführungsformen beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind. Hierbei zeigen
- Fig. 1: eine perspektivische Ansicht einer ersten erfindungsgemäßen Ausführungsform einer Adapterplatte des Adapterplatte-Ausrichtlehre-Systems;
- Fig. 2: eine perspektivische Ansicht der Adapterplatte aus Fig. 1 mit installiertem Crimpwerkzeug;
- Fig. 3: eine weitere perspektivische Ansicht der Adapterplatte aus Fig. 1 mit installiertem Crimpwerkzeug;
- Fig. 4: eine perspektivische Ansicht des Adapterplatte-Ausrichtlehre-Systems mit installiertem Crimpwerkzeug;
- Fig. 5: eine perspektivische Ansicht einer Grundplatte mit Ausrichtlehre; und
- Fig. 6: eine perspektivische Ansicht einer Adapterplatte mit Ausrichtlehre, wobei die Adapterplatte in einer Crimppresse unbeweglich angeordnet ist.

Die Figuren sind lediglich schematisch und nicht maßstabsgetreu. Gleiche Bezugszeichen bezeichnen in den Figuren gleiche oder gleichwirkende Merkmale.

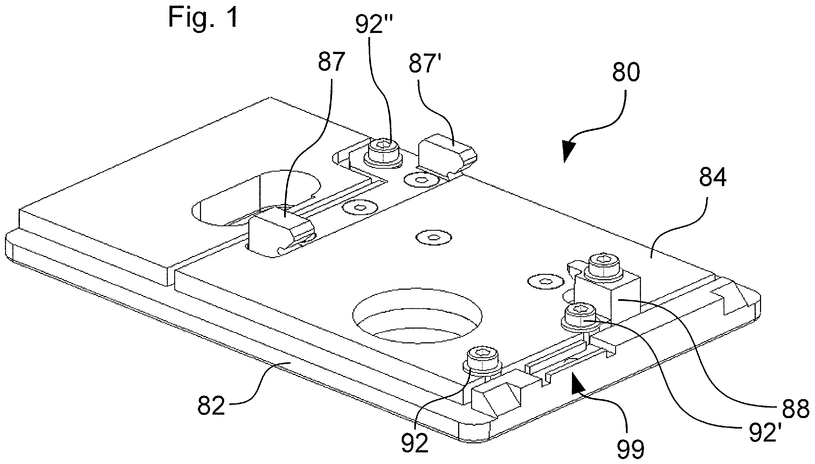

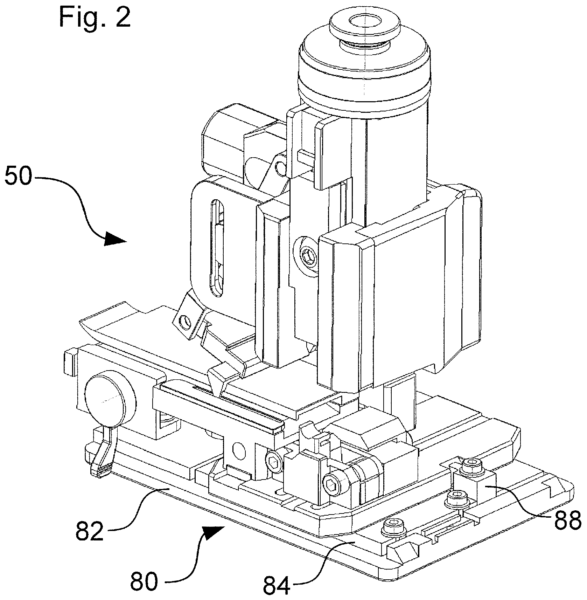

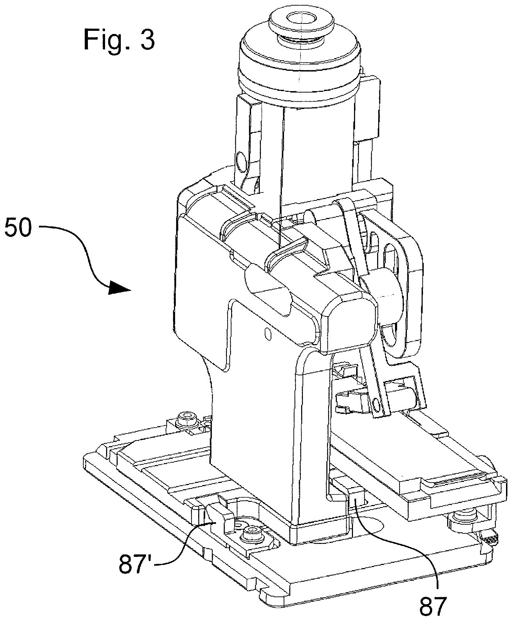

Fig. 1 zeigt eine perspektivische Ansicht einer ersten erfindungsgemäßen Ausführungsform einer Adapterplatte 80 des Adapterplatte-Ausrichtlehre-Systems. Fig. 2 zeigt eine perspektivische Ansicht der Adapterplatte 80 aus Fig. 1 mit installiertem Crimpwerkzeug 50. Fig. 3 zeigt eine weitere perspektivische Ansicht der Adapterplatte 80 aus Fig. 1 mit installiertem Crimpwerkzeug 50.

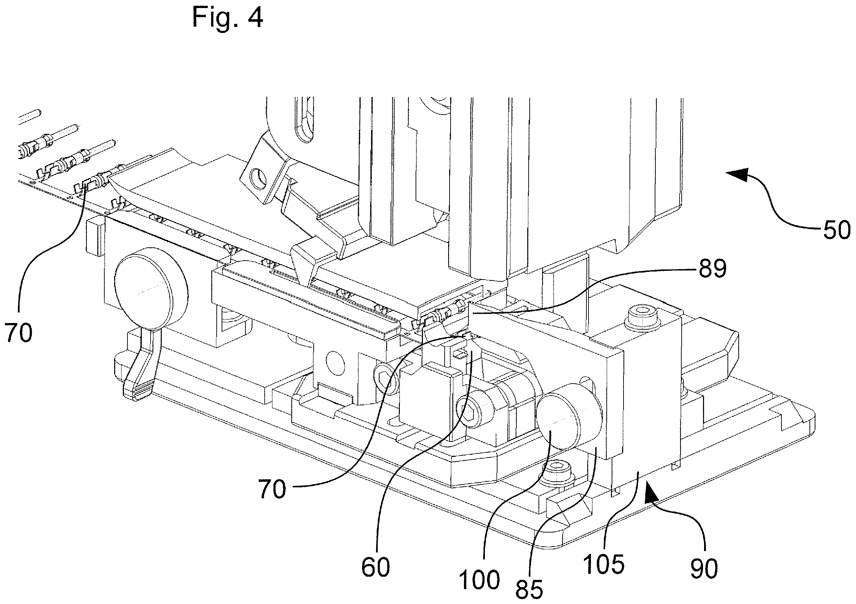

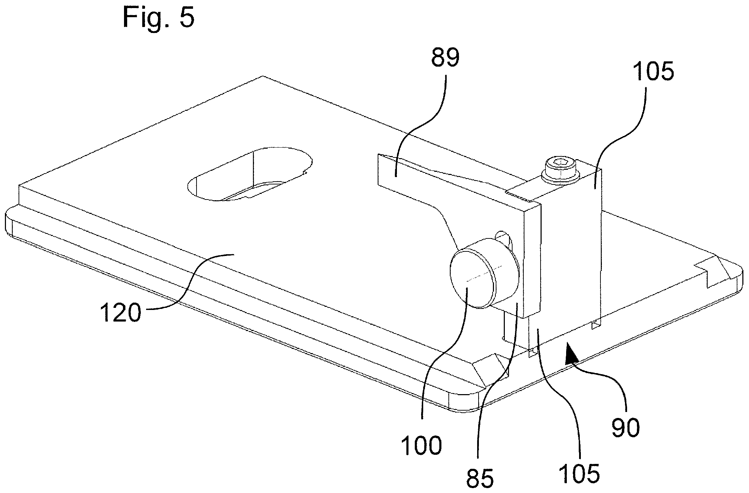

Das Adapterplatte-Ausrichtlehre-System umfasst eine Adapterplatte 80 und eine Ausrichtlehre 90 (siehe Fig. 4 und 5). Die Adapterplatte 80 weist einen Adapterplattenrahmen 82 und eine Aufnahmeplatte 84 auf. Die Aufnahmeplatte 84 ist an dem Adapterplattenrahmen 82 fixierbar bzw. unbeweglich befestigbar. Die Aufnahmeplatte 84 weist drei Klauen 87, 87', 88 auf. Zwei der hakenförmigen Klauen 87, 87' sind starr an der Aufnahmeplatte 84 befestigt. Die dritte hakenförmige Klaue 88 ist beweglich an der Aufnahmeplatte 84 anordenbar. Die drei Klauen 87, 87', 88 dienen zum Einklemmen des Crimpwerkzeugs 50 bzw. Befestigen des Crimpwerkzeugs 50 an der Aufnahmeplatte 84. Die Einheit aus Aufnahmeplatte 84 und daran befestigtem Crimpwerkzeug 50 kann relativ zum Adapterplattenrahmen 82 verschoben werden. Drei Schrauben 92, 92', 92", die auch bei aufgesetztem Crimpwerkzeug 50 zugänglich sind, dienen dazu, die Aufnahmeplatte 84 am Adapterplattenrahmen 82 fest zu ziehen bzw. zu fixieren, nachdem das Crimpwerkzeug 50 (zusammen mit der Aufnahmeplatte 84) mittels der Ausrichtlehre 90 ausgerichtet bzw. positioniert wurde.

Die Aufnahmeplatte 84 ist mittels der drei Schrauben 92, 92', 92" an der Adapterplatte 80 fixierbar bzw. lösbar unbeweglich befestigbar. Lösbar unbeweglich bedeutet, dass im befestigen Zustand keine Relativbewegung zwischen Adapterplattenrahmen 82 und Aufnahmeplatte 84 möglich ist, der befestigte Zustand jedoch aufhebbar ist, so dass eine Relativbewegung zwischen Adapterplattenrahmen 82 und Aufnahmeplatte 84 möglich ist.

Das Crimpwerkzeug 50 wird unbeweglich mit der Aufnahmeplatte 84 verbunden, z.B. durch einen Formschluss. Die Adapterplatte 80 kann unterschiedliche Crimpwerkzeuge halten. Da die Adapterplatte 80 in der Crimppresse 10 bzw. in unterschiedlichen Crimppressen stets an der gleichen Adapterplattenposition relativ zur Crimppresse 10 fixiert bzw. gehalten bzw. unbeweglich angeordnet wird, befindet sich das Crimpwerkzeug 50 stets an der gleichen Position relativ zur Crimppresse 10 (wenn die Adapterplatte 80 in der Crimppresse 10 unbeweglich angeordnet ist). In der Crimppresse 10 fest bzw. unbeweglich angeordnet bedeutet insbesondere, dass das Crimpwerkzeug 50 zwischen der oberen (in Vertikalrichtung beweglichen) Werkzeugaufnahme 11 und der unteren Werkzeugaufnahme 12 unbeweglich angeordnet. Die Adapterplatte 80, auf der das Crimpwerkzeug unbeweglich befestigt ist, kann hierfür direkt bzw. unmittelbar an der Crimppresse 10 befestigt werden oder die Adapterplatte 80 ist an einer weiteren Vorrichtung befestigt bzw. fixiert, die unbeweglich gegenüber der Crimppresse 10 angeordnet ist.

Auch nach dem Verbinden des Crimpwerkzeugs 50 mit der Aufnahmeplatte 84 sind die drei Schrauben 92, 92', 92" zum Befestigen der Aufnahmeplatte 84 am Adapterplattenrahmen 82 zugänglich.

Die Adapterplattenposition ist eine fest vorgegebene Position der Adapterplatte 80 in Bezug zu der Crimppresse 10. Der Rand bzw. die Ränder der Adapterplatte 80 weist in der Adapterplattenposition z.B. jeweils einen festgelegten Abstand zu der oberen Werkzeugaufnahme 11 der Crimppresse 10 und zu der unteren Werkzeugaufnahme 12 der Crimppresse 10 auf.

Fig. 4 zeigt eine perspektivische Ansicht des Adapterplatte-Ausrichtlehre-Systems mit installiertem Crimpwerkzeug 50. Die Adapterplatte 80 weist eine Ausrichtlehrenverbindungsvorrichtung 99 (z.B. in Form mehrerer Aussparungen, in die die Ausrichtlehre 90 eingreift) auf. Die Ausrichtlehre 90 wird mittels der Ausrichtlehrenverbindungsvorrichtung 99 starr, d.h. unbeweglich, an der Adapterplatte 80 in der Ausrichtlehrenposition lösbar befestigt. Die Ausrichtlehrenposition ist eindeutig, d.h. wenn die Ausrichtlehre 90 an der Adapterplatte 80 befestigt ist, befindet sich die Ausrichtlehre 90 (insbesondere der Ausrichtlehrenhalter 105 der Ausrichtlehre 90) stets in der Ausrichtlehrenposition. Der Finger 85 der Ausrichtlehre 90 ist höhenverstellbar. Somit ist die Position des Fingers 85 nur in einer Ebene parallel zu der oberen Oberfläche der Adapterplatte 80 festgelegt. Der Finger 85 ist im Wesentlichen plattenförmig ausgebildet, wobei die Dicke und Höhe des Fingers 85 abnimmt, je weiter man sich von dem Ausrichtlehrenhalter 105 entfernt.

Die Ausrichtlehre 90 umfasst einen Ausrichtlehrenhalter 105, an dem ein Finger 85 in Form eines sich verjüngenden Vorsprungs angeordnet ist. Der Finger 85 ist relativ zum Ausrichtlehrenhalter 105 höhenverstellbar ausgebildet. Somit kann der Finger 85 in unterschiedlichen Abständen zu der Adapterplatte 80 angeordnet werden. Die Ausrichtlehre 90 umfasst zudem eine Rändelschraube 100. Mit der Rändelschraube 100 kann der Finger 85 in unterschiedlichen Höhen bzw. unterschiedlichen Abständen zu der Adapterplatte 80 fixiert bzw. arretiert werden und wieder gelöst werden.

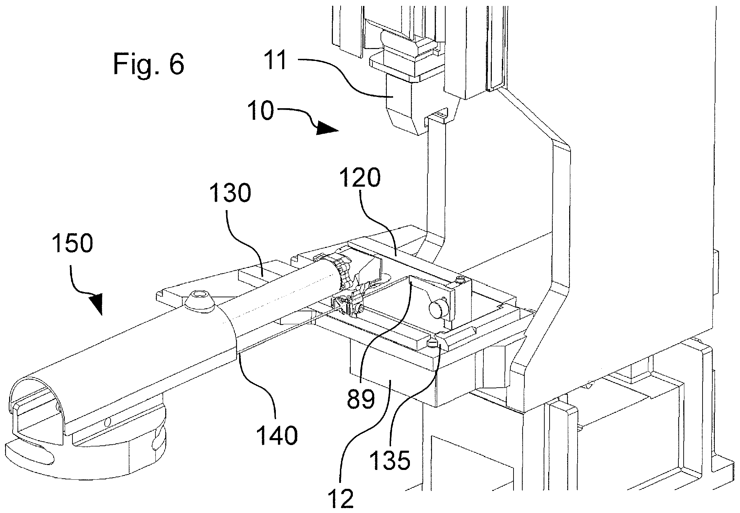

Die Ausrichtlehre 90 ist in genau einer Position (nämlich der Ausrichtlehrenposition) an der Adapterplatte 80 bzw. an dem Adapterplattenrahmen 82 der Adapterplatte 80 befestigbar. Das Crimpwerkzeug 50 wird auf der Adapterplatte 80 derart ausgerichtet, dass eine Kante 89 des Fingers 85 der Ausrichtlehre 90 mit einem Amboss 60 des Crimpwerkzeugs 50 (z.B. mit der Mitte des Ambosses 60) fluchtet. Wenn nun die Ausrichtlehre 90 (oder eine baugleiche Ausrichtlehre) an einer anderen Adapterplatte 80, die baugleich zu der in Fig. 4 gezeigten Adapterplatten 80 ist, in der Ausrichtlehrenposition befestigt wird, kann das weitere Crimpwerkzeug 50 auf dieser anderen Adapterplatte 80 in einer Crimpwerkzeugposition relativ zu dem Finger 85 der Ausrichtlehre 90 positioniert und fixiert wird. Hierdurch ist das weitere Crimpwerkzeug 50 an der gleichen Position in Bezug auf die andere Adapterplatte 80 fixiert wie das in Fig. 4 gezeigte Crimpwerkzeug 50 in Bezug auf die in Fig. 4 gezeigte Adapterplatte 80. Somit ist sichergestellt, dass bei einem Austauschen eines ersten Crimpwerkzeugs 50, das auf einer ersten Adapterplatte 80 in einer Crimpwerkzeugposition fixiert ist und in einer Crimppresse 10 in einer Prozessposition angeordnet ist, gegen ein zweites Crimpwerkzeug 50, das auf einer zweiten Adapterplatte 80 in einer Crimpwerkzeugposition fixiert ist, das zweite Crimpwerkzeug 50 präzise in der Prozessposition in der Crimppresse 10 angeordnet wird. Hierdurch wird erreicht, dass ein neues Einrichten bzw. Ausrichten des zweiten Crimpwerkzeugs 50 in Bezug auf die Crimppresse 10 bzw. das Kabel 140 bzw. umgekehrt nicht notwendig ist (vgl. auch Fig. 6). Dies verringert die Zeit, in der bei einem Wechsel bzw. Austauschen des Crimpwerkzeugs 50 gegen ein anderes Crimpwerkzeug der Betrieb der Crimppresse 10 unterbrochen ist.

Die Crimpwerkzeugposition ist dann erreicht, wenn ein festgelegter Teil des Crimpwerkzeugs 50 (z.B. der Amboss 60, insbesondere die Mitte des Ambosses 60) sich unterhalb des Fingers 85 der Ausrichtlehre 90 befindet. Wenn diese Bedingung erfüllt ist, befindet sich das Crimpwerkzeug 50 in der Crimpwerkzeugposition relativ bzw. in Bezug zu der Ausrichtlehre 90 und folglich relativ zur Adapterplatte 80. Es kann auch zweckmäßig sein, die Crimpwerkzeugposition zu bestimmen, indem ein Crimpkontakt des Crimpwerkzeugs 50 zu dem Finger 85 der Ausrichtlehre 90 ausgerichtet wird. Beispielsweise soll der Finger 85 der Ausrichtlehre 90 einen vorgegebenen Abstand (z.B. den Überstand des Kabels über den Crimpkontakt) zu dem bzw. einem Ende des Crimpkontakts haben. Diese Position bzw. dieser Punkt muss nicht das hintere Ende des Ambosses 60 sein.

Fig. 5 zeigt eine perspektivische Ansicht einer Grundplatte 120 mit Ausrichtlehre 90.

Die Grundplatte 120 weist die gleichen äußeren Dimensionen wie die Adapterplatte 80 und weist eine baugliche Ausrichtlehrenverbindungsvorrichtung 99 auf. Die Grundplatte 120 ist jedoch nicht geeignet, ein Crimpwerkzeug 50 auf der Grundplatte 120 zu fixieren. Die Grundplatte 120 dient dazu, das Leiterende des Kabels 140 in Bezug bzw. relativ zur Crimppresse 10 auszurichten.

Da die Grundplatte 120 die gleichen äußeren Dimensionen wie die Adapterplatte 80 aufweist und die Ausrichtlehre 90 in der gleichen Ausrichtlehrenposition an der Grundplatte 120 befestigt wird wie an der Adapterplatte 80, befindet sich die Ausrichtlehre 90 an der gleichen Position in Bezug auf die Crimppresse 10, wenn die Grundplatte 120 unbeweglich in der Crimppresse 10 in der Adapterplattenposition angeordnet wird. Die Grundplatte 120 dient zum Einrichten der Prozessposition. Insbesondere dient die Grundplatte 120 zum Ausrichten bzw. Einrichten der Position des Leiterendes des Kabels 140.

Fig. 6 zeigt eine perspektivische Ansicht einer Adapterplatte 80 mit Ausrichtlehre 90, wobei die Adapterplatte 80 in einer Crimppresse 10 unbeweglich angeordnet ist.

Die Adapterplatte 80 ist mittels Führungsschienen 130 der Crimppresse 10, die über den Adapterplattenrahmen 82 greifen, und einem Anschlagteil 135 fixiert. Die Adapterplatte 80 wird von einem nicht gezeigten Mitnehmer gegen das Anschlagteil 135 gedrückt. Das Leiterende des Kabels 140, das mit dem Crimpkontakt 70 verbunden werden soll, wird nun in Bezug auf die Ausrichtlehre 90 ausgerichtet. Dies bedeutet, dass das Kabel 140 bewegt wird, bis sich das Leiterende des Kabels 140 an der Kante 89 des Fingers 85 befindet.

Für das Einstellen der Prozessposition verfügt die Crimppresse 10 bzw. Kabelverarbeitungsmaschine über eine Programmfunktion, die es erlaubt, ein abisoliertes Kabel 140 mit der Schwenkeinheit 150 zur Bearbeitungsstation zu bringen, dort mittels Handeingaben die Kabelspitze in Kabelrichtung und quer dazu zu verschieben und die so eingestellte Prozessposition abzuspeichern. Mit der Ausrichtlehre 90 ist dies wesentlich einfacher auszuführen als mit einem Crimpwerkzeug 50, da die Kante 89 des Fingers 85 der Ausrichtlehre 90 ideal sichtbar ist. Die vertikale Verstellmöglichkeit bzw. Höhenverstellbarkeit des Fingers 85 ist vorteilhaft, da das Kabel 140 beim Crimpen abgesenkt wird und dadurch beim Einrichten über dem Crimpkontakt 70 steht.

Wird die Prozessposition mit Hilfe einer geometrisch identischen bzw. baugleichen Ausrichtlehre 90 eingestellt, wie sie zum Positionieren des Crimpwerkzeugs 50 auf der Adapterplatte 80 verwendet wird, so ist sichergestellt, dass die Lage der Kabelspitze nach dem Einwechseln eines beliebigen Crimpwerkzeuges korrekt ist, d.h. das Leiterende des Kabels 140 über dem Amboss 60 liegt, so dass der Crimpvorgang ohne weiteres Ausrichten durchgeführt werden kann.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Adapterplatte-Ausrichtlehre-System umfassend
- eine Adapterplatte (80) zum Halten eines Crimpwerkzeuges (50) an unterschiedlichen Positionen und
- eine Ausrichtlehre (90) zum Ausrichten des Crimpwerkzeuges (50) in einer fest vorgegebenen Crimpwerkzeugposition relativ zu der Ausrichtlehre (90),
wobei die Adapterplatte (80) in einer Crimppresse (10), die zur Herstellung einer Crimpverbindung mittels des Crimpwerkzeuges (50), das ein Leiterende eines Kabels (140) mit einem Crimpkontakt (70) verbindet, ausgebildet ist, in einer fest vorgegebenen Adapterplattenposition unbeweglich anordenbar ist, **dadurch gekennzeichnet, dass** die Ausrichtlehre (90) und die Adapterplatte (80) derart ausgebildet sind, dass die Ausrichtlehre (90) derart an der Adapterplatte (80) befestigbar ist, dass die Ausrichtlehre (90) in einer fest vorgegebenen Ausrichtlehrenposition relativ zu der Adapterplatte (80) angeordnet ist.

2. Adapterplatte-Ausrichtlehre-System nach Anspruch 1, wobei zumindest ein Teil der Ausrichtlehre (90) höhenverstellbar ausgebildet ist und in unterschiedlichen Abständen zu der Adapterplatte (80) arretierbar ist.

3. Adapterplatte-Ausrichtlehre-System nach Anspruch 1 oder 2, wobei die Adapterplatte (80) zur Aufnahme des Crimpwerkzeuges (50) ausgebildet ist und das Crimpwerkzeug (50) an mehreren unterschiedlichen Positionen, insbesondere kontinuierlich, an der Adapterplatte (80) lösbar unbeweglich befestigbar ist.

4. Adapterplatte-Ausrichtlehre-System nach einem der vorhergehenden Ansprüche, wobei die Adapterplatte (80) einen Adapterplattenrahmen (82) und eine Aufnahmeplatte (84) aufweist,
wobei die Aufnahmeplatte (84) relativ zu dem Adapterplattenrahmen (82) verschiebbar ausgebildet ist und die Aufnahmeplatte (84) an dem Adapterplattenrahmen (82) in unterschiedlichen Positionen unbeweglich befestigbar ist,
und wobei die Aufnahmeplatte (84) derart ausgebildet ist, dass das Crimpwerkzeug (50) an der Aufnahmeplatte (84) lösbar unbeweglich befestigbar ist.

5. Adapterplatte-Ausrichtlehre-System nach einem der vorhergehenden Ansprüche, ferner umfassend eine Grundplatte (120), wobei die Ausrichtlehre (90) und die Grundplatte (120) derart ausgebildet sind, dass die Ausrichtlehre (90) in der Ausrichtlehrenposition an der Grundplatte (120) befestigbar ist, wobei die Grundplatte (120) an der vorgegebenen Adapterplattenposition an der Crimppresse (10) derart unbeweglich lösbar befestigbar ist, dass sich die Ausrichtlehre (90) in einer Position relativ zu der Crimppresse (10) befindet, die der Position der Ausrichtlehre (90) entspricht, wenn die Ausrichtlehre (90) in der Ausrichtlehrenposition an der Adapterplatte (80) befestigt ist und die Adapterplatte (80) an der Adapterplattenposition in der Crimppresse (10) unbeweglich angeordnet ist.

6. Adapterplatte-Ausrichtlehre-System nach einem der vorhergehenden Ansprüche, wobei die Ausrichtlehre (90) einen sich verjüngenden Vorsprung aufweist.

7. Verfahren zum Ausrichten eines Crimpwerkzeuges (50) für eine Crimppresse (10), die zur Herstellung einer Crimpverbindung mittels des Crimpwerkzeuges (50), das ein Leiterende eines Kabels (140) mit einem Crimpkontakt (70) verbindet, ausgebildet ist, relativ zu einer Adapterplatte (80), wobei die Adapterplatte (80) in der Crimppresse (10) in einer fest vorgegebenen Adapterplattenposition unbeweglich anordenbar ist, wobei das Crimpwerkzeug (50) an unterschiedlichen Positionen an der Adapterplatte (80) lösbar unbeweglich befestigbar ist, wobei das Verfahren folgende Schritte umfasst:
- Befestigen der Ausrichtlehre (90) an der Adapterplatte (80) derart, dass die Ausrichtlehre (90) in einer fest vorgegebenen Ausrichtlehrenposition relativ zu der Adapterplatte (80) angeordnet ist,
- Verschieben des Crimpwerkzeuges (50) relativ zur Adapterplatte (80), bis sich das Crimpwerkzeug (50) in einer fest vorgegebenen Crimpwerkzeugposition relativ zu der Ausrichtlehre (90) befindet, und
- Befestigen des Crimpwerkzeuges (50) an der Adapterplatte (80), so dass das Crimpwerkzeug (50) relativ zur Adapterplatte (80) lösbar unbeweglich befestigt ist.

8. Verfahren nach Anspruch 7, ferner den Schritt umfassend:
Ausrichten des Leiterendes des Kabels (140) relativ zur Ausrichtlehre (90), während die Adapterplatte (80) mit der Ausrichtlehre (90) in der Crimppresse (10) unbeweglich lösbar angeordnet ist.

9. Verfahren nach Anspruch 7 oder 8, ferner den Schritt umfassend:
Ausrichten des Leiterendes des Kabels (140) relativ zur Ausrichtlehre (90).

10. Verfahren nach Anspruch 9, wobei der Schritt des Ausrichtens des Leiterendes des Kabels (140) relativ zur Ausrichtlehre (90) ausgeführt wird, während die Ausrichtlehre (90) an der Adapterplatte (80) ohne ein Crimpwerkzeug (50) oder an einer Grundplatte (120) befestigt ist, die in der Crimppresse (10) derart unbeweglich angeordnet ist, dass sich die Ausrichtlehre (90) in einer Position relativ zu der Crimppresse (10) befindet, die der Position der Ausrichtlehre (90) entspricht, wenn die Ausrichtlehre (90) in der Ausrichtlehrenposition an der Adapterplatte (80) befestigt ist und die Adapterplatte (80) an der Adapterplattenposition in der Crimppresse (10) unbeweglich angeordnet ist.

11. Verfahren nach einem der Ansprüche 7-10, wobei das Verschieben des Crimpwerkzeuges (50) relativ zur Adapterplatte (80), bis sich das Crimpwerkzeug (50) an der bestimmten Crimpwerkzeugposition relativ zu der Ausrichtlehre (90) befindet, durchgeführt wird, indem das Crimpwerkzeug (50) grob in der Crimpwerkzeugposition ausgerichtet wird, während sich ein höhenverstellbarer Teil der Ausrichtlehre (90) in einem ersten Abstand zu der Adapterplatte (80) befindet, und das Crimpwerkzeug (50) präzise in der Crimpwerkzeugposition ausgerichtet wird, während sich der höhenverstellbare Teil in einem zweiten Abstand zu der Adapterplatte (80) befindet, wobei der zweite Abstand kleiner als der erste Abstand ist.

12. Verfahren nach einem der Ansprüche 7-11, wobei die Adapterplatte (80) einen Adapterplattenrahmen (82) und eine Aufnahmeplatte (84) aufweist, ferner folgenden Schritt umfassend:
unbewegliches Befestigen des Crimpwerkzeugs (50) auf der Aufnahmeplatte (84),
wobei
bei dem Schritt des Verschiebens des Crimpwerkzeuges (50) relativ zum Adapterplattenrahmen (82), bis sich das Crimpwerkzeug (50) in der fest vorgegebenen Crimpwerkzeugposition relativ zu der Ausrichtlehre (90) befindet, das Crimpwerkzeug (50) zusammen mit der Aufnahmeplatte (84) relativ zum Adapterplattenrahmen (82) verschoben wird, und
bei dem Schritt des Befestigens des Crimpwerkzeuges (50) an der Aufnahmeplatte (84), so dass das Crimpwerkzeug (50) relativ zur Aufnahmeplatte (84) lösbar unbeweglich befestigt ist, die Aufnahmeplatte (84) am Adapterplattenrahmen (82) lösbar unbeweglich befestigt wird.

## Claims

1. Adapter plate alignment gauge system, comprising
- an adapter plate (80) for holding a crimping tool (50) in different positions and
- an alignment gauge (90) for aligning the crimping tool (50) in a fixedly predetermined crimping tool position relative to the alignment gauge (90), it being possible to arrange the adapter plate (80) immovably in a crimping press (10) which is designed to establish a crimping connection by means of the crimping tool (50), which connects a conductor end of a cable (140) to a crimping contact (70),
**characterized in that** the alignment gauge (90) and the adapter plate (80) are designed such that the alignment gauge (90) can be fastened to the adapter plate (80) such that the alignment gauge (90) is arranged in a fixedly predetermined alignment gauge position relative to the adapter plate (80).

2. Adapter plate alignment gauge system according to claim 1, wherein at least part of the alignment gauge (90) is height-adjustable and can be locked at different distances from the adapter plate (80).

3. Adapter plate alignment gauge system according to either claim 1 or claim 2, wherein the adapter plate (80) is designed to receive the crimping tool (50) and the crimping tool (50) can be detachably and immovably fastened to the adapter plate (80) in a plurality of different positions, in particular continuously.

4. Adapter plate alignment gauge system according to any of the preceding claims, wherein the adapter plate (80) comprises an adapter plate frame (82) and a receiving plate (84),
wherein the receiving plate (84) is displaceable relative to the adapter plate frame (82) and the receiving plate (84) can be immovably fastened to the adapter plate frame (82) in different positions,
and wherein the receiving plate (84) is designed such that the crimping tool (50) can be detachably and immovably fastened to the receiving plate (84).

5. Adapter plate alignment gauge system according to any of the preceding claims, further comprising a base plate (120), wherein the alignment gauge (90) and the base plate (120) are designed such that the alignment gauge (90) can be fastened to the base plate (120) in the alignment gauge position, wherein the base plate (120) can be immovably and detachably fastened to the crimping press (10) in the predetermined adapter plate position such that the alignment gauge (90) is in a position relative to the crimping press (10) which corresponds to the position of the alignment gauge (90) when the alignment gauge (90) is fastened to the adapter plate (80) in the alignment gauge position and the adapter plate (80) is immovably arranged in the crimping press (10) in the adapter plate position.

6. Adapter plate alignment gauge system according to any of the preceding claims, wherein the alignment gauge (90) has a tapering projection.

7. Method for aligning a crimping tool (50) for a crimping press (10), which press is designed to establish a crimping connection by means of the crimping tool (50), which connects a conductor end of a cable (140) to a crimp contact (70), relative to an adapter plate (80), wherein the adapter plate (80) can be immovably arranged in the crimping press (10) in a fixedly predetermined adapter plate position, wherein the crimping tool (50) can be detachably and immovably fastened to the adapter plate (80) in different positions, wherein the method comprises the following steps:
- fastening the alignment gauge (90) to the adapter plate (80) such that the alignment gauge (90) is arranged in a fixedly predetermined alignment gauge position relative to the adapter plate (80),
- displacing the crimping tool (50) relative to the adapter plate (80) until the crimping tool (50) is in a fixedly predetermined crimping tool position relative to the alignment gauge (90), and
- fastening the crimping tool (50) to the adapter plate (80) such that the crimping tool (50) is detachably and immovably fastened relative to the adapter plate (80).

8. Method according to claim 7, further comprising the step of:
aligning the conductor end of the cable (140) relative to the alignment gauge (90), while the adapter plate (80) is arranged, together with the alignment gauge (90), immovably and detachably in the crimping press (10).

9. Method according to claim 7 or claim 8, further comprising the step of:
aligning the conductor end of the cable (140) relative to the alignment gauge (90).

10. Method according to claim 9, wherein the step of aligning the conductor end of the cable (140) relative to the alignment gauge (90) is carried out while the alignment gauge (90) is fastened to the adapter plate (80) without a crimping tool (50) or to a base plate (120) which is immovably arranged in the crimping press (10) such that the alignment gauge (90) is in a position relative to the crimping press (10) that corresponds to the position of the alignment gauge (90) when the alignment gauge (90) is fastened to the adapter plate (80) in the alignment gauge position and the adapter plate (80) is immovably arranged in the crimping press (10) in the adapter plate position.

11. Method according to any of claims 7-10, wherein the crimping tool (50) is displaced relative to the adapter plate (80) until the crimping tool (50) is in the specified crimping tool position relative to the alignment gauge (90), by the crimping tool (50) being aligned roughly in the crimping tool position while a height-adjustable part of the alignment gauge (90) is at a first distance from the adapter plate (80), and by the crimping tool (50) being aligned precisely in the crimping tool position while the height-adjustable part is at a second distance from the adapter plate (80), wherein the second distance is smaller than the first distance.

12. Method according to any of claims 7-11, wherein the adapter plate (80) comprises an adapter plate frame (82) and a receiving plate (84), further comprising the following step:
immovably fastening the crimping tool (50) to the receiving plate (84),
wherein in the step of displacing the crimping tool (50) relative to the adapter plate frame (82) until the crimping tool (50) is in the fixedly predetermined crimping tool position relative to the alignment gauge (90), the crimping tool (50) is displaced, together with the receiving plate (84), relative to the adapter plate frame (82), and
in the step of fastening the crimping tool (50) to the receiving plate (84) such that the crimping tool (50) is detachably and immovably fastened relative to the receiving plate (84), the receiving plate (84) is detachably and immovably fastened to the adapter plate frame (82).

## Revendications

1. Système de guide d'alignement pour plaque d'adaptation comprenant
- une plaque d'adaptation (80) permettant de maintenir un outil de sertissage (50) dans différentes positions, et
- un guide d'alignement (90) permettant d'aligner l'outil de sertissage (50) dans une position d'outil de sertissage fixe prédéterminée par rapport au guide d'alignement (90),
la plaque d'adaptation (80) étant formée dans une presse à sertir (10) disposée pour établir une connexion sertie au moyen de l'outil de sertissage (50), lequel relie une extrémité conductrice d'un câble (140) à un contact à sertir (70) et peut être disposée dans une position fixe prédéterminée,
**caractérisé en ce que** le guide d'alignement (90) et la plaque d'adaptation (80) sont conçus de sorte que le guide d'alignement (90) puisse être fixé sur la plaque d'adaptation (80), **en ce que** le guide d'alignement (90) est disposé dans une position de guide d'alignement fixe prédéterminée par rapport à la plaque d'adaptation (80).

2. Système de guide d'alignement pour plaque d'adaptation selon la revendication 1, dans lequel au moins une partie du guide d'alignement (90) est réglable en hauteur et peut être verrouillée à différentes distances de la plaque d'adaptation (80).

3. Système de guide d'alignement pour plaque d'adaptation selon la revendication 1 ou 2, dans lequel la plaque d'adaptation (80) est conçue pour recevoir l'outil de sertissage (50) et l'outil de sertissage (50) peut être fixé de manière amovible et immobile sur la plaque d'adaptation (80) dans plusieurs positions différentes, notamment en continu.

4. Système de guide d'alignement pour plaque d'adaptation selon l'une des revendications précédentes,
dans lequel la plaque d'adaptation (80) comprend un cadre de plaque d'adaptation (82) et une plaque de réception (84),
dans lequel la plaque de réception (84) peut coulisser par rapport au cadre de plaque d'adaptation (82) et la plaque de réception (84) peut être fixée de manière immobile au cadre de plaque d'adaptation (82) dans différentes positions,
et dans lequel la plaque de réception (84) est conçue de sorte que l'outil de sertissage (50) soit fixé de manière amovible et immobile sur la plaque de réception (84).

5. Système de guide d'alignement pour plaque d'adaptation selon l'une des revendications précédentes, comprenant en outre une plaque de base (120), le guide d'alignement (90) et la plaque de base (120) étant configurées de telle sorte que le guide d'alignement (90) puisse être fixé sur la plaque de base (120) dans la position du guide d'alignement, la plaque de base (120) pouvant être fixée de manière amovible et immobile à la presse à sertir (10) dans la position prédéterminée de la plaque d'adaptation, de sorte que le guide d'alignement (90) se retrouve dans une position par rapport à la presse à sertir (10), laquelle position correspond à la position du guide d'alignement (90) lorsque le guide d'alignement (90) est fixé sur la plaque d'adaptation (80) dans la position du guide d'alignement et la plaque d'adaptation (80) est disposée de manière fixe dans la position de la plaque d'adaptation de la presse à sertir (10).

6. Système de guide d'alignement pour plaque d'adaptation selon l'une des revendications précédentes, dans lequel le guide d'alignement (90) présente une saillie conique.

7. Procédé d'alignement d'un outil de sertissage (50) pour une presse à sertir (10) destinée à réaliser une connexion sertie au moyen de l'outil de sertissage (50), lequel relie une extrémité conductrice d'un câble (140) à un contact à sertir (70) par rapport à une plaque d'adaptation (80), la plaque d'adaptation (80) pouvant être disposée de manière fixe dans une position prédéterminée immobile dans la presse à sertir (10), l'outil de sertissage (50) pouvant être fixé de manière amovible et immobile sur la plaque d'adaptation (80) dans différentes positions, le procédé comprenant les étapes suivantes :
- Fixation du guide d'alignement (90) sur la plaque d'adaptation (80), de sorte que le guide d'alignement (90) soit disposé dans une position de guide d'alignement fixe prédéterminée par rapport à la plaque d'adaptation (80),
- Déplacement de l'outil de sertissage (50) par rapport à la plaque d'adaptation (80), jusqu'à ce que l'outil de sertissage (50) se retrouve dans une position d'outil de sertissage fixe prédéterminée par rapport au guide d'alignement (90), et
- Fixation de l'outil de sertissage (50) sur la plaque d'adaptation (80), de sorte que l'outil de sertissage (50) soit fixé de manière amovible et immobile par rapport à la plaque d'adaptation (80).

8. Procédé selon la revendication 7, comprenant en outre l'étape suivante :
Alignement de l'extrémité conductrice du câble (140) par rapport au guide d'alignement (90) tandis que la plaque d'adaptation (80) comportant le guide d'alignement (90) est disposée de manière amovible et immobile dans la presse à sertir (10).

9. Procédé selon la revendication 7 ou 8, comprenant en outre l'étape suivante :
Alignement de l'extrémité conductrice du câble (140) par rapport au guide d'alignement (90).

10. Procédé selon la revendication 9, dans lequel l'étape d'alignement de l'extrémité conductrice du câble (140) est réalisée par rapport au guide d'alignement (90), tandis que le guide d'alignement (90) est fixé sur la plaque d'adaptation (80) sans outil de sertissage (50) ou sur une plaque de base (120) disposée de manière fixe dans la presse à sertir (10), de sorte que le guide d'alignement (90) se retrouve dans une position par rapport à la presse à sertir (10), laquelle position correspond à la position du guide d'alignement (90) lorsque le guide d'alignement (90) est fixé sur la plaque d'adaptation (80) dans la position du guide d'alignement et la plaque d'adaptation (80) est disposée de manière fixe à la position de la plaque d'adaptation dans la presse à sertir (10).

11. Procédé selon l'une des revendications 7 à 10, dans lequel le déplacement de l'outil de sertissage (50) par rapport à la plaque d'adaptation (80) est effectué, jusqu'à ce que l'outil de sertissage (50) se retrouve dans la position prédéterminée de l'outil de sertissage par rapport au guide d'alignement (90), en alignant approximativement l'outil de sertissage (50) dans la position de l'outil de sertissage tandis qu'une partie réglable en hauteur du guide d'alignement (90) se situe à une première distance de la plaque d'adaptation (80) et en orientant l'outil de sertissage (50) avec précision dans la position de l'outil de sertissage, tandis que la partie réglable en hauteur se situe à une seconde distance de la plaque d'adaptation (80), la seconde distance étant inférieure à la première.

12. Procédé selon l'une des revendications 7 à 11, dans lequel la plaque d'adaptation (80) comprend un cadre de plaque d'adaptation (82) et une plaque de réception (84), comprenant en outre l'étape suivante :
fixation immobile de l'outil de sertissage (50) sur la plaque de réception (84), l'outil de sertissage (50) ainsi que la plaque de réception (84) étant coulissés par rapport au cadre de la plaque d'adaptation (82) à l'étape de déplacement de l'outil de sertissage (50) par rapport au cadre de plaque d'adaptation (82), jusqu'à ce que l'outil de sertissage (50) se retrouve dans la position fixe prédéterminée de l'outil de sertissage (50) par rapport au guide d'alignement (90), et
la plaque réception (84) étant fixée de manière amovible et immobile sur le cadre de plaque d'adaptation (82) à l'étape de fixation de l'outil de sertissage (50) sur la plaque de réception (84), de telle sorte que l'outil de sertissage (50) soit fixé de manière amovible et immobile par rapport à la plaque de réception (84).
